# EUROPEAN PATENT SPECIFICATION

(11) **EP 4 195 889 B1**
(45) Date of publication and mention of the grant of the patent: **15.07.2026**
(21) Application number: 22862317.9
(22) Date of filing: 06.09.2022
(51) Int. Cl.: H05K 5/02, H04M 1/02, B32B 5/02, B32B 5/26, B32B 7/12, B32B 17/04, B32B 27/08, B32B 27/12, B32B 27/36

(54) **HOUSING ASSEMBLY AND PREPARATION METHOD THEREFOR, AND TERMINAL**
GEHÄUSEANORDNUNG UND HERSTELLUNGSVERFAHREN DAFÜR SOWIE ENDGERÄT
ENSEMBLE BOÎTIER, SON PROCÉDÉ DE PRÉPARATION, ET TERMINAL

(30) Priority: 09.10.2021 CN 202111177453
(43) Date of publication of application: 14.06.2023
(73) Proprietor: Honor Device Co., Ltd., Shenzhen, Guangdong 518040 (CN)
(72) Inventor: GAO, Chengjie, Guangdong 518040 (CN)
(74) Representative: Epping - Hermann - Fischer
(86) International application number: PCT/CN2022/117313
(87) International publication number: WO 2023/056815

(56) References cited:
- EP-A1- 3 750 706
- CN-A- 108 250 711
- CN-A- 110 901 110
- CN-A- 110 901 110
- CN-A- 111 645 383
- CN-A- 113 141 429
- CN-A- 113 141 429
- CN-B- 108 270 886
- JP-A- 2009 094 171
- US-A1- 2014 060 874

## Description

### TECHNICAL FIELD

This application relates to the field of terminals, and in particular, to a housing assembly, a preparation method thereof, and a terminal.

### BACKGROUND

Electronic devices such as smart phones and tablet computers use a glass fiber plate as a battery cover, and therefore are characterized by high toughness and light weight, and are not only resistant to fall but also thinner. To obtain enough strength, the glass fiber plate is generally formed by a woven glass cloth. However, the woven glass cloth has a woven texture. In a 3D molding process, the woven texture may be easily rubbed into an optical decorative layer, affecting a decorative effect. As a result, an advanced decorative effect cannot be achieved in the industry.

CN 110 901 110 A relates to a method for manufacturing a housing component, including the following steps: obtain a transparent plate, the transparent plate includes an inner surface and an outer surface that are opposite to each other; a decorative layer and an ink layer are sequentially stacked on the inner surface of the transparent plate to obtain a composite plate layer; hot bending the composite board layer to obtain a 2.5D composite board layer or a 3D composite board layer; obtaining a glass fiber board, the glass fiber board is adapted to the shape of the composite board layer after hot bending, and the glass fiber board is vacuum-attached to the ink layer away from the transparent board by hot melt adhesive side.

CN 108 270 886 B relates to a mobile phone casing, comprising: a PET layer, an optical coating layer, an ink layer, a protective layer, a UV adhesive layer and a glass fiber board layer arranged in sequence, and the surface roughness of the glass fiber board layer is less than or equal to 0.005 mm; wherein, the optical coating layer is disposed on one surface of the PET layer, the ink layer is disposed on the surface of the optical coating layer opposite to the PET layer, and the protective layer is disposed on the ink layer on the surface opposite to the optical coating layer, the UV glue layer is arranged on the surface of the protective layer opposite to the ink layer, and the glass fiber board layer is arranged on the surface of the UV glue layer.

EP 3 750 706 A1 relates to a portable electronic device housing comprising a plate defining: a front major surface; a back major surface opposite the front major surface; and a periphery; wherein the plate is formed of an asymmetric laminate comprising two or more laminae, at least one of the laminae including a plurality of fibers dispersed within a polymeric matrix material; and a sidewall comprising a polymeric body coupled to the plate with the polymeric body disposed along at least a majority of the periphery of the plate and extending away from the back major surface of the plate in a direction opposite the front major surface of the plate.

US 2014/060874 A1 relates to a manufacturing method of a housing of an electronic device, comprising: providing a first fibered fabric and two resin films; respectively laminating the two resin films on two opposite sides of the first fibered fabric for forming a laminating structure; heating the laminating structure for softening the two resin films of the laminating structure; respectively pressing the two softened resin films, such that the two softened resin films are filled into gaps between fiber bundles of the fibered fabric for forming a fibered fabric layer; solidifying the fibered fabric layer; and stacking and thermal pressing a plurality of second fibered fabric on the fibered fabric layer for forming a composite stack plate.

CN 113 141 429 A relates to a color-changing and colorful mobile phone back cover, comprising a substrate layer, characterized in that: the upper surface of the substrate layer is provided with a scratch-resistant hardened layer. The lower surface of the substrate layer is coated with a colorful layer, the lower surface of the colorful layer is coated with a textured color-changing layer, and the color-changing layer is a photochromic layer or a thermochromic layer, the lower surface of the color changing layer is coated with an insulating reflective layer, the lower surface of the insulating reflective layer is printed with an insulating ink layer. The lower surface of the insulating ink layer is covered with one or more glass fiber reinforcement boards through an adhesive layer.

### SUMMARY

This application provides a housing assembly, a preparation method thereof, and a terminal, so as to resolve a problem that a glass fiber plate cannot be used as a battery cover to achieve an advanced decorative effect. The invention is set out in the appended set of claims.

To achieve the foregoing objective, the following technical solutions are used in this application:
According to an aspect, this application provides a housing assembly, including a woven glass fiber plate layer, a cover layer, and a highlight layer that are sequentially laminated; the highlight layer is configured to create a specular effect; a heat shrinkage difference between the woven glass fiber plate layer and the cover layer does not exceed 20%, wherein the heat shrinkage is a percentage of a difference between sizes of a film before and after hot processing; a thickness of the cover layer is less than 0.2 mm; and a light transmittance of the cover layer is less than 0.05%, wherein the cover layer is a high-filling coating layer formed of a filler, a solvent, and a film forming resin, a cover resin layer or an unidirectional glass fiber plate layer. The housing assembly further comprises an ink layer disposed between the cover layer and the highlight layer.

In this application, a woven glass fiber plate is used as a support structure of a housing assembly, and a cover layer that meets requirements that a heat shrinkage difference does not exceed 20%, a thickness does not exceed 0.2 mm, and a light transmittance does not exceed 0.05% is used to cover the woven glass fiber plate, so as to prevent a woven texture of the woven glass fiber plate from being rubbed into the highlight layer in a thermoforming process, thereby achieving advanced optical effects such as highlight on a glass housing assembly.

According to another aspect, this application further provides a housing assembly, including a woven glass fiber plate layer, a cover layer, a decorative film, and a highlight layer that are sequentially laminated, where the decorative film includes an optical coating layer, a texture layer, and a plastic substrate layer that are sequentially disposed. The decorative film has a glare effect similar to a CD texture or a laser texture, so that the housing assembly presents both a highlight effect and a glare effect as a battery back cover.

To ensure an appearance of the housing assembly, the plastic substrate layer of the decorative film needs to meet requirements that a heat shrinkage difference does not exceed 20%, a thickness is less than or equal to 0.2 mm, and a light transmittance is less than or equal to 0.05%. In addition, plastic properties of the plastic substrate layer of the decorative film need to meet the following requirements: An elongation is not less than 150%, a tensile strength is not less than 50 MPa, so that phenomena such as cracks do not occur during 3D stretching.

In this application, the cover layer may be a structure such as a cover resin layer, a high-filling coating layer, or a unidirectional glass fiber plate layer. On the one hand, the cover layer has a heat shrinkage close to that of a woven glass fiber plate layer, and when 3D hot pressing is performed, a woven texture is not rubbed into a surface of a 3D housing assembly, which does not affect an appearance of the cover layer and display of other optical textures, such as highlight and glare. On the other hand, the cover layer has a relatively small thickness and a relatively low light transmittance, and enhances display of advanced optical effects such as highlight and glare.

According to another aspect, this application provides a method for preparing the foregoing housing assembly.

In an embodiment, the housing assembly is prepared according to the following method, that is, first performing 3D molding and then performing laminating:
performing 3D hot pressing molding on a woven glass fiber cloth prepreg, and then sequentially forming a cover layer and a coating highlight layer to obtain a housing assembly, wherein
a heat shrinkage difference between the woven glass fiber plate layer and the cover layer does not exceed 20%, wherein the heat shrinkage is a percentage of a difference between sizes of a film before and after hot processing;
a thickness of the cover layer is less than 0.2 mm; and
a light transmittance of the cover layer is less than 0.05%, wherein the cover layer is a high-filling coating layer formed of a filler, a solvent, and a film forming resin, a cover resin layer or an unidirectional glass fiber plate layer, the method further comprising:
coating an ink layer on the cover layer after the cover layer is formed.

In another embodiment, the housing assembly may be prepared according to the following method, that is, first performing laminating and then performing 3D molding:
laminating a woven glass fiber cloth prepreg and then laminating the woven glass fiber cloth prepreg with a cover layer, and coating an obtained laminated structure with a highlight layer after 3D hot pressing molding, to obtain the housing assembly, wherein
a heat shrinkage difference between the woven glass fiber plate layer and the cover layer does not exceed 20%, wherein the heat shrinkage is a percentage of a difference between sizes of a film before and after hot processing;
a thickness of the cover layer is less than 0.2 mm; and
a light transmittance of the cover layer is less than 0.05%, wherein the cover layer is a high-filling coating layer formed of a filler, a solvent, and a film forming resin, a cover resin layer or an unidirectional glass fiber plate layer, the method further comprising:
coating an ink layer on the cover layer after the cover layer is formed.

In an embodiment, the housing assembly may be prepared according to the following method:
impregnating and curing a woven glass fiber cloth in a thermoplastic resin, to obtain a thermoplastic resin glass fiber plate; and
forming a cover layer on the thermoplastic resin glass fiber plate, and coating the obtained laminated structure with a highlight layer after 3D hot pressing molding, to obtain the housing assembly, wherein
a heat shrinkage difference between the woven glass fiber plate layer and the cover layer does not exceed 20%, wherein the heat shrinkage is a percentage of a difference between sizes of a film before and after hot processing;
a thickness of the cover layer is less than 0.2 mm; and
a light transmittance of the cover layer is less than 0.05%, wherein the cover layer is a high-filling coating layer formed of a filler, a solvent, and a film forming resin, a cover resin layer or an unidirectional glass fiber plate layer, the method further comprising:
coating an ink layer on the cover layer after the cover layer is formed.

According to another aspect, this application provides a terminal that includes the foregoing housing assembly. The terminal uses the foregoing housing assembly as a battery cover or a back cover, and therefore has advanced optical decorative effects such as highlight and glare, which are beautiful.

### BRIEF DESCRIPTION OF DRAWINGS

To describe technical methods in embodiments of this application more clearly, the following briefly describes accompanying drawings required for describing the embodiments.
FIG. 1 is a schematic diagram of a structure of a terminal according to an embodiment of this application;
FIG. 2 is a schematic diagram of a structure of a battery cover according to a first embodiment of this application;
FIG. 3 is a flowchart of a first preparation process of the battery cover according to the first embodiment of this application;
FIG. 4 is a flowchart of a second preparation process of the battery cover according to the first embodiment of this application;
FIG. 5 is a flowchart of a third preparation process of the battery cover according to the first embodiment of this application;
FIG. 6 is a schematic diagram of a structure of a battery cover according to a second embodiment of this application; and
FIG. 7 is a schematic diagram of a structure of a battery cover according to a an example of this application.

### DESCRIPTION OF EMBODIMENTS

In embodiments of this application, the word such as "as an example" or "for example" is used to represent giving an example, an illustration, or a description. In embodiments of this application, any embodiment or design solution described as "as an example" or "for example" shall not be explained as being preferred or advantageous over other embodiments or design solutions. To be precise, the use of the word such as "as an example" or "for example" is intended to present a related concept in a specific manner.

A terminal mentioned in this application may be any device with communication and storage functions, such as a smartphone, a cellular phone, a cordless phone, a session initiation protocol (Session Initiation Protocol, SIP) phone, a tablet computer, a personal digital assistant (Personal Digital Assistant, PAD), a notebook computer, a digital camera, an e-book reader, a portable multimedia player, a handheld device with a wireless communication function, a computing device or another processing device connected to a wireless modem, an in-vehicle device, a wearable device, and a 5G terminal device, which is not limited in the embodiments of this application.

In embodiments of this application, a glass fiber plate means a woven glass fiber plate, which is also referred to as a woven glass fiber composite plate. The glass fiber plate is formed by a glass fiber cloth made of glass fiber woven according to the warp and weft, and then reinforced with thermoplastic or thermosetting resin.

In embodiments of this application, a light transmittance means a light transmission capability of a medium, and affects a visual effect of the medium; and a thickness means a distance between upper and lower surfaces of the medium. A person skilled in the art may understand that a thickness affects a light transmittance. The light transmittance in embodiments of this application means a light transmittance of each layer of a battery cover of a mobile phone in a general thickness. For example, to control a thickness of a battery cover of a mobile phone, a thickness of a high-filling coating layer generally does not exceed 0.2 mm, and a light transmittance of a high-filling coating layer also means a light transmittance when a thickness of the high-filling coating layer does not exceed 0.2 mm.

A heat shrinkage described in this solution means a percentage of a difference between sizes of a film before and after hot processing, including a longitudinal heat shrinkage and a lateral heat shrinkage. A longitudinal heat shrinkage and a lateral heat shrinkage of a woven glass fiber plate are relatively consistent, and are both described in this solution as a heat shrinkage.

An optical texture described in the present invention means a linear texture presented by a laminated film under an action of light, and includes effects such as specular highlight and glare. The specular highlight means that the laminated film is relatively bright, and can create a mirror effect. The glare means a texture in which a laminated film has different brightness and colors, and shows a ripple effect similar to that of light reflected by an optical disc or a laser ripple effect.

In the present invention, both tensile strength and elongation are performance parameters that represent plasticity of a material, and the tensile strength is also referred to as a tensile strength, which means a maximum tensile stress on a sample until the sample is broken in a tensile test. The elongation is a percentage of a ratio of a total deformation ΔL of a gauge segment after the sample is stretched and broken to an original gauge length L: δ=ΔL/L× 100%.

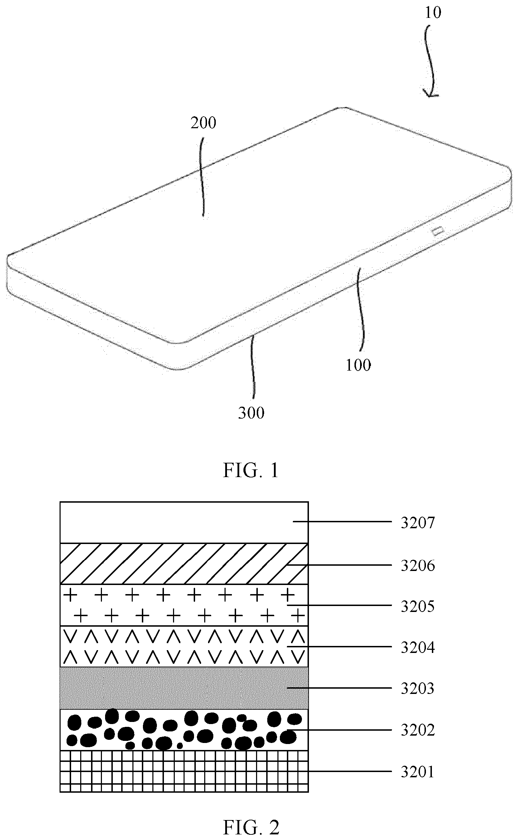

This application uses a smartphone as an example for description. FIG. 1 is a schematic diagram of a structure of a terminal according to an embodiment of this application. In an embodiment, the terminal 10 includes a middle frame 100, a display 200, and a battery cover 300. The middle frame 100 connects the display 200 and the battery cover 300 to form a storage space, and components such as a main board, a memory, and a power supply of the terminal 10 are disposed in the storage space.

A glass fiber plate has good mechanical strength and is currently used to prepare a three-dimensional (3D) battery cover of a mobile phone. However, in a preparation process, the glass fiber plate and other plates need to be heated to a softening temperature above which deformation can occur. However, woven glass fiber inside the glass fiber plate is inorganic and does not soften. Therefore, a woven texture of the glass fiber plate may be easily rubbed into the other plates during the deformation, which affects an appearance effect of the battery cover. In this solution, the foregoing problem is resolved by setting a laminated structure. On the one hand, a woven texture of the glass fiber plate is covered. On the other hand, the woven texture of the glass fiber plate is not rubbed into another plate, thereby achieving an advanced texture effect of a battery cover, especially a highlight effect and/or a glare effect.

FIG. 2 is a schematic diagram of a structure of a battery cover according to a first embodiment of this application. In this embodiment, the battery cover 300 includes a woven glass fiber plate layer 3201, a high-filling coating layer 3202, and a highlight layer 3207 that are sequentially laminated.

As a main structure of the battery cover 300, the woven glass fiber plate layer 3201 has a relatively high mechanical strength and a relatively low appearance roughness, and mainly plays a supporting role. In an embodiment, the woven glass fiber plate layer 3201 is obtained by laminating a multi-layer woven glass fiber cloth prepreg, the woven glass fiber cloth prepreg is obtained by coating a woven glass fiber cloth in a resin solution and then performing drying, and the woven glass fiber cloth is woven of glass fiber. The glass fiber includes but is not limited to E-glass fiber, S-glass fiber, C-glass fiber, A-glass fiber, and the like. In an embodiment, a resin solution includes a matrix resin, a curing agent, a promoter, and a solvent. In an embodiment, the matrix resin is a thermosetting resin, and includes but is not limited to a bisphenol A epoxy resin, a phenolic epoxy resin, an alicyclic epoxy resin, a nitrogen-containing multifunctional epoxy resin, a phenolic resin, a bismaleimide resin, a benzoxazine resin, and the like. In an embodiment, the curing agent may be selected from a phenolic type curing agent, an acid anhydride curing agent, an amine curing agent, a dicyandiamide curing agent, or the like, for example, a nadikic anhydride, a methylnadikic anhydride, a methyl tetrahydrophthalic anhydride, a diphenyl ether tetra-phthalic anhydride, a benzophenonetetracarboxylic dianhydride, a methyl-cyclohexene-tetracarboxylic anhydride, a diphenylbenzidine, or a dicyandiamide. In an embodiment, the promoter includes an imidazole promoter or an amine promoter, such as imidazole or 2-methylimidazole. In an embodiment, the thermosetting resin is a thermosetting epoxy resin, and the curing agent is an amine curing agent. In an embodiment, the resin solution includes a thermoplastic resin and a solvent, and the thermoplastic resin includes but is not limited to a thermoplastic polyurethane, a thermoplastic polyamide, a thermoplastic polyetherketone, a thermoplastic polyphenylene sulfide, and the like.

A person skilled in the art may understand that "multi-layer" in embodiments of this application means at least two or more layers, for example, two layers, three layers, and four layers. A thickness of each layer of woven glass fiber cloth prepreg is 0.003~0.12 mm, and a thickness of the woven glass fiber plate layer 3001 is 0.05~1 mm. For example, when a thickness of a woven glass fiber cloth prepreg is 0.1 mm, four layers are required to prepare a woven glass fiber plate layer with a thickness of 0.4 mm; and when a thickness of the woven glass fiber cloth prepreg is 0.01 mm, 20 layers are required to prepare a woven glass fiber plate layer with a thickness of 0.2 mm. In an embodiment, to take into account a thickness and mechanical strength of the battery cap 300, a thickness of the woven glass fiber plate layer is 0.1~0.5 mm. In an embodiment, a thickness of the woven glass fiber plate layer is 0.35~0.45 mm.

A function of the high-filling coating layer 3202 is to shield the woven texture of the woven glass fiber plate layer 3201, to prevent a specular highlight effect of the highlight layer 3207 from being affected. In an embodiment, a thickness of the high-filling coating layer 3202 is less than 0.2 mm. In an embodiment, a thickness of the high-filling coating layer 3202 is less than 0.15 mm. In an embodiment, a thickness of the high-filling coating layer 3202 is 0.05~0.1 mm. In an embodiment, a light transmittance of the high-filling coating layer 3202 is less than 0.05%. In an embodiment, a light transmittance of the high-filling coating layer 3202 is 0.

The difference between a heat shrinkage of the high-filling coating layer 3202 and a heat shrinkage of the woven glass fiber plate layer 3201 does not exceed 20% of the heat shrinkage of the woven glass fiber plate layer 3201. For example, the heat shrinkage of the woven glass fiber plate layer 3201 is 0.2, and the heat shrinkage of the high-filling coating layer 3202 is 0.16~0.24. When the heat shrinkage of the woven glass fiber plate layer 3201 and the heat shrinkage of the high-filling coating layer 3202 remain within the foregoing range, it can be ensured that the woven glass fiber plate layer and the high-filling coating layer are deformed in a same manner when deforming under heat, so that a texture of the woven glass fiber is not rubbed into the high-filling coating layer, which does not affect a shielding effect of the high-filling coating layer. In an embodiment, a difference between a heat shrinkage of the high-filling coating layer 3202 and a heat shrinkage of the woven glass fiber plate layer 3201 does not exceed 15% of the heat shrinkage of the woven glass fiber plate layer 3201. The heat shrinkage of the woven glass fiber plate layer 3201 is 0.2, and the heat shrinkage of the high-filling coating layer 3202 is 0.16~0.23. In an embodiment, a difference between a heat shrinkage of the high-filling coating layer 3202 and a heat shrinkage of the woven glass fiber plate layer 3201 does not exceed 10% of the heat shrinkage of the woven glass fiber plate layer 3201. The heat shrinkage of the woven glass fiber plate layer 3201 is 0.2, and the heat shrinkage of the high-filling coating layer 3202 is 0.18~0.28. In this solution, a light transmittance of the high-filling coating layer 3202 is less than 0.05%, and when a difference between a heat shrinkage of the high-filling coating layer 3202 and a heat shrinkage of the woven glass fiber plate layer 3201 does not exceed 20% of the heat shrinkage of the woven glass fiber plate layer 3201, a fiber woven texture can be covered, and no fiber woven texture is formed at the high-filling coating layer 3202 during hot pressing, so that display of an optical texture such as specular highlight is not affected.

The high-filling coating layer 3202 is formed of a filler, a solvent, and a film forming resin, where the filler includes but is not limited to white filler, such as titanium dioxide, and black filler, such as fumed silica and talcum. The high-filling coating layer 3202 has an advantage of easy processing, and may be formed at the woven glass fiber plate layer 3201 through coating, casting, or laminating, or may be directly disposed between the woven glass fiber plate layer 3201 to form a laminated structure through hot pressing.

In an embodiment, the high-filling coating layer 3202 may be further replaced by a cover resin layer. It may be understood that a difference between the cover resin layer and the high-filling coating layer 3202 lies in that, at the high-filling coating layer, it is mainly a filler that performs a covering function, and a resin is used to form a film, while at the cover resin layer, it is mainly a resin, such as a macromolecular resin or a special modified resin that has a relatively high covering capability, that performs a covering function; and requirements for a thickness, a light transmittance, and a heat shrinkage of the cover resin layer are the same as those of the high-filling coating layer. Details are not described herein again in the present invention. An advantage of using a cover resin layer as a barrier layer is that performance is easier to control, and quality of batches of obtained laminated structures is relatively stable.

The function of the highlight layer 3207 is to create a specular highlight effect, and a highlight coating may be coated to form a highlight layer through flow coating, spraying, or inkjetting. A composition of the highlight coating in this application is not specially limited, provided that a highlight effect can be achieved.

In this application, a high-filling coating layer or a cover resin layer with a heat shrinkage close to and not exceeding 20% of that of a woven glass fiber layer, and with a light transmittance not exceeding 5% of that of the woven glass fiber layer is used to shield a woven texture of the woven glass fiber layer. On the one hand, this does not affect display of an optical effect. On the other hand, this does not affect an appearance of a battery cover.

The battery cover further includes an ink layer 3203 disposed between the high-filling coating layer 3202 and the highlight layer 3207. In an embodiment, a thickness of the ink layer 3203 is 10~60 µm. In an embodiment, a thickness of the ink layer 3203 is 15~50 µm. It may be understood that when the high-filling coating layer 3202 has enough covering power, this solution has no limitation on covering power, namely, a light transmittance, of the ink layer 3203. In an embodiment, the ink layer 3203 may also have covering power, and a light transmittance of the ink layer 3203 is less than 50%. In an embodiment, the ink layer 3203 may be a black ink layer, a white ink layer, or a gray ink layer, and a light transmittance thereof is less than 0.05%. In an embodiment, a light transmittance of the ink layer 3203 is 0. The ink layer 3203 may be formed at the high-filling coating layer 3203 through screen printing, coating, or spraying.

In an embodiment, the battery cover further includes an optical coating layer 3204, a texture layer 3205, and a plastic substrate layer 3206 that are disposed between the high-filling coating layer 3202 and the highlight layer 3207; and the optical coating layer 3204, the texture layer 3205, and the plastic substrate layer 3206 form a laminated structure of a decorative film with a glare effect, where the optical coating layer 3204 is in contact with the high-filling coating layer 3202, and the plastic substrate layer 3206 is in contact with the highlight layer 3207.

The plastic substrate layer 3206 is used as a substrate layer of the texture layer 3205, and may also be used as a substrate for coating to achieve a highlight effect. In an embodiment, the plastic substrate layer 3206 includes but is not limited to a polycarbonate (PC), a glass fiber reinforced polycarbonate, a polyethylene terephthalate (PET), an aramid fiber reinforced PET such as a Kevlar reinforced PET, a polyvinyl chloride (PVC), a thermoplastic polyurethane elastomer (TPU), a polycarbonate (PC)/thermoplastic polyurethane elastomer (TPU) composite material, and the like. In an embodiment, a thickness of the plastic substrate layer 3206 is 0.01~0.15 mm. In an embodiment, a thickness of the plastic substrate layer 3206 is 0.05~0.13 mm.

In an embodiment, an elongation of the plastic substrate layer 3206 is not less than 150%, and a tensile strength is not less than 45 MPa. In an embodiment, an elongation of the plastic substrate layer 3206 is not less than 180%, and a tensile strength is not less than 50 MPa. In an embodiment, an elongation of the plastic substrate layer 3206 is not less than 200%, and a tensile strength is not less than 50 MPa. A plastic substrate layer that meets the foregoing condition can ensure that no appearance defect occurs in an obtained laminated structure in a process of preparing the 3D battery cover. When the tensile strength and the elongation are lower than the foregoing condition, the plastic substrate layer is broken when 3D thermal bending is performed to prepare the 3D battery cover, which affects an appearance of the battery cover.

The texture layer 3205 and the optical coating layer 3204 may provide an optical texture effect with rich light and shadow effects, to achieve diversified appearance decorative effects of the battery cover 300. In an embodiment, the texture layer 3205 and the optical coating layer 3204 may be obtained by using the following method: Transferring an optical texture onto the plastic substrate layer 3206 to form a UV film (that is, the texture layer 3205) through UV curing (UV), and then performing physical vapor deposition (PVD) coating on the UV film to form the optical coating layer 3204. In an embodiment, the texture layer 3205 and the optical coating layer 3204 may be obtained by using the following method: Directly performing laser etching at the plastic substrate layer 3206 to form the texture layer 3205, and then performing PVD coating to form the optical coating layer 3204. In an embodiment, the optical texture may be a texture that can achieve a glare effect, such as a CD texture or a laser texture. In an embodiment, the PVD coating may be an optical coating layer formed by performing evaporation coating, magnetron sputtering coating, or ion coating with a metal, a metal oxide, or a non-metal oxide as a target material. To achieve a desired optical texture effect, a person skilled in the art may select a single target material for coating, or may select two or more different target materials for coating, which is not limited in this application. In an embodiment, the metal target includes but is not limited to aluminum, titanium, zirconium, chromium, niobium, and the like; the metal oxide target includes but is not limited to titanium dioxide; and the non-metal oxide target includes but is not limited to silicon dioxide. In an embodiment, a thickness of the texture layer 3205 is 2~15 µm. In an embodiment, a thickness of the optical coating layer 3204 is 50 nm to 600 nm.

In an embodiment, the battery cover further includes an ink layer 3203 disposed between the high-filling coating layer 3202 and the optical coating layer 3204. The ink layer 3203, on the one hand, is used as a protective layer of the optical coating layer 3204, and, on the other hand, can improve a shielding effect of the high-filling coating 3202. In an embodiment, a thickness of the ink layer 3203 is 10~60 µm. In an embodiment, a thickness of the ink layer 3203 is 15~50 µm. In an embodiment, the ink layer 3203 may be a black ink layer, a white ink layer, or a gray ink layer, and a light transmittance thereof is less than 0.05%. In an embodiment, a light transmittance of the ink layer 3203 is 0. The ink layer 3203 may be formed at the optical coating layer 3204 through screen printing, coating, or spraying.

In an embodiment, a total thickness of the ink layer 3203, the optical coating layer 3204, the texture layer 3205, and the plastic substrate layer 3206 is less than 0.15 mm.

In an embodiment, the battery cover 300 further includes an adhesive layer (not shown in the figure), where the adhesive layer may be disposed between the ink layer 3203 and the high-filling coating layer 3202, or may be disposed between the woven glass fiber plate layer 3201 and the high-filling coating layer 3202, to perform an adhesive function. In an embodiment, a difference between a heat shrinkage of the adhesive layer and a heat shrinkage of the woven glass fiber plate layer 3201 does not exceed 20% of the heat shrinkage of the woven glass fiber plate layer 3201. In an embodiment, a difference between a heat shrinkage of the adhesive layer and a heat shrinkage of the woven glass fiber plate layer 3201 does not exceed 15% of the heat shrinkage of the woven glass fiber plate layer 3201. In an embodiment, a difference between a heat shrinkage of the adhesive layer and a heat shrinkage of the woven glass fiber plate layer 3201 does not exceed 10% of the heat shrinkage of the woven glass fiber plate layer 3201. It may be understood that when the high-filling coating layer 3202 has enough covering power, this solution has no limitation on covering power, namely, a light transmittance, of the adhesive layer. In an embodiment, the adhesive layer may also have covering power, and the light transmittance of the adhesive layer is less than 50%. In an embodiment, a total thickness of the high-filling coating layer 3202 and the adhesive layer is less than 0.2 mm.

In an embodiment, the ink layer 3203, the optical coating layer 3204, the texture layer 3205, the plastic substrate layer 3206, and the highlight layer 3207 form a laminated structure of a decorative film with glare and highlight effects.

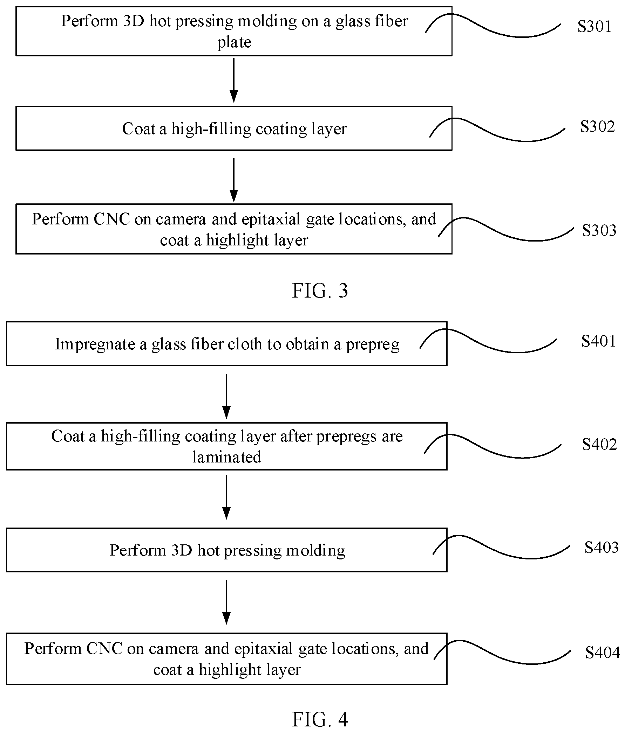

FIG. 3 is a flowchart of a first preparation process of the battery cover according to a first embodiment of this application. In an embodiment, the battery cover is prepared according to the following steps:
Step S301: Coat a woven glass fiber cloth in a resin solution including an epoxy resin and an amine curing agent, and perform drying to obtain a prepreg; and
   cut three to four layers of prepreg, laminate the prepreg in a 3D mold, heat the prepreg at 120~200°C for 10~30 minutes, and then perform cold pressing on the prepreg at 0~1 MPa for 20~100s, to obtain a 3D glass fiber plate.
Step S302: Coat a high-filling coating layer on the 3D glass fiber plate.
Step S303: Perform CNC on camera and epitaxial gate locations, and coat a highlight layer to the high-filling coating layer, where a thickness of the highlight layer is 15~22 µm, and a total thickness of a battery cover is less than 0.6 mm.

Between step S302 and step S303, the preparation process further includes coating an ink layer at the high-filling coating layer, where the ink layer and the high-filling coating layer play a shielding role together, and correspondingly, the highlight layer is formed at the ink layer.

In an embodiment, after the coating of the ink layer and before step S303, the preparation process further includes: laminating, under vacuum and at 40~80°C, a decorative film and the 3D structure obtained after the coating of the ink layer, placing the decorative film and the 3D structure on a pre-laminating jig, performing hot pressing for the second time at 80~150°C for 30~60s for lamination, and then performing cold pressing at normal temperature at 0~1 MPa for 20~100s. The decorative film includes a laminated structure of an optical coating layer, a texture layer, and a plastic substrate layer. The decorative film has a glare effect, and a film thickness is less than 0.15 mm. When laminating is performed, the optical coating layer is in contact with the ink layer, and correspondingly, the highlight layer is formed at the plastic substrate layer. In an embodiment, when the decorative film and the 3D structure obtained after the coating of the ink layer are laminated, an adhesive is further included, where the adhesive is disposed between the optical coating layer and the ink layer to form an adhesive layer, and a thickness of the adhesive layer is less than 0.2 mm.

In another embodiment, between step S302 and step S303, the preparation process further includes: laminating, under vacuum and at 40~80°C, a decorative film and the 3D structure obtained after step S302, placing the decorative film and the 3D structure on a pre-laminating jig, performing hot pressing for the second time at 80~150°C for 30~60s for lamination, and then performing cold pressing at normal temperature at 0~1 MPa for 20~100s. The decorative film includes a laminated structure of an ink layer, an optical coating layer, a texture layer, and a plastic substrate layer. The decorative film has a glare effect, and a film thickness is less than 0.15 mm. When laminating is performed, the ink layer is in contact with the high-filling coating layer, and correspondingly, the highlight layer is formed at the plastic substrate layer. In an embodiment, when the decorative film and the 3D structure obtained in step S302 are laminated, an adhesive is further included, where the adhesive is disposed between the ink layer and the high-filling coating layer to form an adhesive layer, and a thickness of the adhesive layer is less than 0.2 mm.

In an embodiment, the decorative film further includes a highlight layer disposed at the plastic substrate layer. In this case, no highlight layer needs to be painted in step S303.

In the embodiment, the prepreg, the adhesive layer, the ink layer, the optical coating layer, the texture layer, and the plastic substrate layer meet the foregoing performance parameters. Details are not described herein again in this application.

FIG. 4 is a flowchart of a second preparation process of the battery cover according to a first embodiment of this application. In an embodiment, the battery cover is prepared according to the following steps:
Step S401: Coat a woven glass fiber cloth in a resin solution including an epoxy resin and an amine curing agent, and perform drying to obtain a prepreg.
Step S402: Laminate three to four layers of prepreg, and coat a high-filling coating on a surface of the prepreg, to perform initial curing.
Step S403: Cut the laminated structure obtained in step S402, perform hot pressing on the laminated structure for 10~30 minutes at 120~200°C in a 3D mold, and then perform cold pressing at normal temperature at 0~1 MPa for 20~100s, to form a 3D laminated structure.
Step S404: Perform CNC on camera and epitaxial gate locations, and coat a highlight layer to a high-filling coating layer of the 3D laminated structure, where a thickness of the highlight layer is 15~22 µm, and a total thickness of the battery cover is less than 0.6 mm.

Compared with the first preparation process, in the second preparation process, a high-filling coating layer is coated on a surface of a prepreg, to perform 3D molding. This does not cause a case in which a part such as a corner of a 3D pattern is not tightly laminated, which is more conducive to display of a 3D effect.

Between step S403 and step S404, the preparation process further includes coating an ink layer at the high-filling coating layer of the 3D laminated structure, and correspondingly, the highlight layer is formed at the ink layer.

In an embodiment, after the coating of the ink layer and before step S404, the preparation process further includes: laminating, under vacuum and at 40~80°C, a decorative film and the 3D structure obtained after the coating of the ink layer, placing the decorative film and the 3D structure on a pre-laminating jig, performing hot pressing for the second time at 80~150°C for 30~60s for lamination, and then performing cold pressing at normal temperature at 0~1 MPa for 20~100s. The decorative film includes a laminated structure of an optical coating layer, a texture layer, and a plastic substrate layer. The decorative film has a glare effect, and a film thickness is less than 0.15 mm. When laminating is performed, the optical coating layer is in contact with the ink layer, and correspondingly, the highlight layer is formed at the plastic substrate layer. In an embodiment, when the decorative film and the 3D structure obtained after the coating of the ink layer are laminated, an adhesive is further included, where the adhesive is disposed between the optical coating layer and the ink layer to form an adhesive layer, and a thickness of the adhesive layer is less than 0.2 mm.

In another embodiment, between step S403 and step S404, the preparation process further includes: laminating, under vacuum and at 40~80°C, a decorative film and the 3D structure obtained after step S403, placing the decorative film and the 3D structure on a pre-laminating jig, performing hot pressing for the second time at 80~150°C for 30~60s for lamination, and then performing cold pressing at normal temperature at 0~1 MPa for 20~100s. The decorative film includes a laminated structure of an ink layer, an optical coating layer, a texture layer, and a plastic substrate layer. The decorative film has a glare effect, and a film thickness is less than 0.15 mm. When laminating is performed, the ink layer is in contact with the high-filling coating layer, and correspondingly, the highlight layer is formed at the plastic substrate layer. In an embodiment, when the decorative film and the 3D structure obtained in step S403 are laminated, an adhesive is further included, where the adhesive is disposed between the ink layer and the high-filling coating layer to form an adhesive layer, and a thickness of the adhesive layer is less than 0.2 mm.

**In** another embodiment, between step S402 and step S403, the preparation process further includes: laminating, under vacuum and at 40~80°C, a decorative film and the initially cured laminated structure obtained after step S402, placing the decorative film and the initially cured laminated structure on a pre-laminating jig, performing plane hot pressing at 80~150°C for 30~60s, and then performing cold pressing at normal temperature at 0~1 MPa for 20~100s. The decorative film includes a laminated structure of an ink layer, an optical coating layer, a texture layer, and a plastic substrate layer. The decorative film has a glare effect, and a film thickness is less than 0.15 mm. When laminating is performed, the ink layer is in contact with the high-filling coating layer, and correspondingly, the highlight layer is formed at the plastic substrate layer. In an embodiment, when the decorative film and the laminated structure obtained in step S402 are laminated, an adhesive is further included, where the adhesive is disposed between the ink layer and the high-filling coating layer to form an adhesive layer, and a thickness of the adhesive layer is less than 0.2 mm.

**In** an embodiment, the decorative film further includes a highlight layer disposed at the plastic substrate layer. In this case, no highlight layer needs to be painted in step S404.

**In** the embodiment, the prepreg, the adhesive layer, the ink layer, the optical coating layer, the texture layer, and the plastic substrate layer meet the foregoing performance parameters. Details are not described herein again in this application.

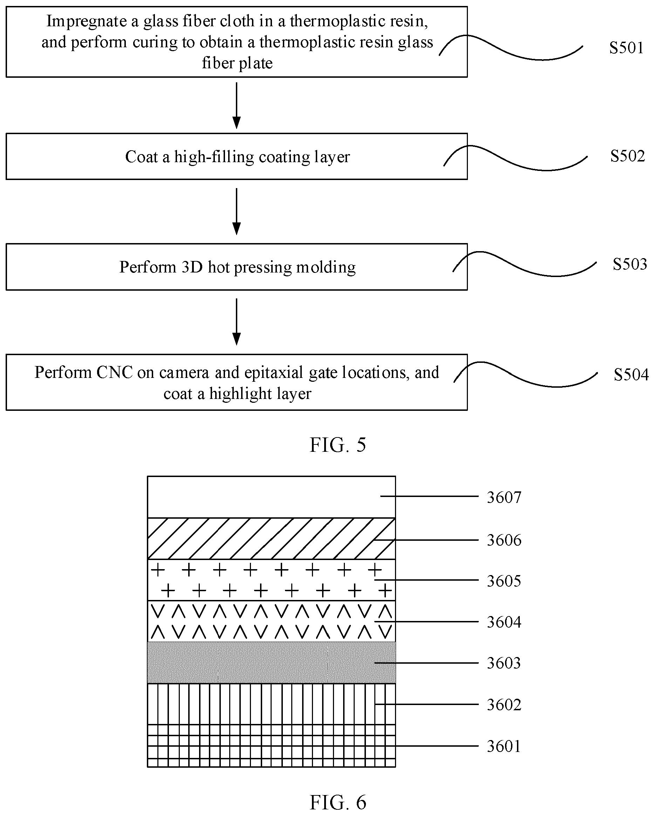

FIG. 5 is a flowchart of a third preparation process of the battery cover according to the first embodiment of this application. In an embodiment, the battery cover is prepared according to the following steps:
Step S501: Coat a woven glass fiber cloth in a thermoplastic resin solution, perform drying to obtain a thermoplastic resin prepreg, and cure three to four layers of thermoplastic resin prepreg at 150~180°C, to obtain a thermoplastic resin glass fiber plate.
Step S502: Coat a high-filling coating layer on a surface of a thermoplastic resin glass fiber plate, to perform initial coating.
Step S503: Cut the laminated structure obtained in step S502, laminate the laminated structure in a 3D mold, perform hot pressing on the laminated structure for 10~30 minutes at 120~200°C, and then perform cold pressing at normal temperature at 0~1 MPa for 20~100s, to form a 3D laminated structure.
Step S504: Perform CNC on camera and epitaxial gate locations, and coat a highlight layer to a high-filling coating layer of the 3D laminated structure, where a thickness of the highlight layer is 15~22 µm, and a total thickness of the battery cover is less than 0.6 mm.

Compared with the first preparation process and the second preparation process, in the third preparation process, a woven glass fiber plate is prepared by using a thermoplastic resin, which is more conducive to processing of a 3D pattern.

Between step S503 and step S504, the preparation process further includes coating an ink layer at the high-filling coating layer of the 3D laminated structure, and correspondingly, the highlight layer is formed at the ink layer.

In an embodiment, after the coating of the ink layer and before step S504, the preparation process further includes: laminating, under vacuum and at 40~80°C, a decorative film and the 3D structure obtained after the coating of the ink layer, placing the decorative film and the 3D structure on a pre-laminating jig, performing hot pressing for the second time at 80~150°C for 30~60s for lamination, and then performing cold pressing at normal temperature at 0~1 MPa for 20~100s. The decorative film includes a laminated structure of an optical coating layer, a texture layer, and a plastic substrate layer. The decorative film has a glare effect, and a film thickness is less than 0.15 mm. When laminating is performed, the optical coating layer is in contact with the ink layer, and correspondingly, the highlight layer is formed at the plastic substrate layer. In an embodiment, when the decorative film and the 3D structure obtained after the coating of the ink layer are laminated, an adhesive is further included, where the adhesive is disposed between the optical coating layer and the ink layer to form an adhesive layer, and a thickness of the adhesive layer is less than 0.2 mm.

In another embodiment, between step S503 and step S504, the preparation process further includes: laminating, under vacuum and at 40~80°C, a decorative film and the 3D structure obtained after step S403, placing the decorative film and the 3D structure on a pre-laminating jig, performing hot pressing for the second time at 80~150°C for 30~60s for lamination, and then performing cold pressing at a normal temperature at 0~1 MPa for 20~100s. The decorative film includes a laminated structure of an ink layer, an optical coating layer, a texture layer, and a plastic substrate layer. The decorative film has a glare effect, and a film thickness is less than 0.15 mm. When laminating is performed, the ink layer is in contact with the high-filling coating layer, and correspondingly, the highlight layer is formed at the plastic substrate layer. In an embodiment, when the decorative film and the 3D structure obtained in step S403 are laminated, an adhesive is further included, where the adhesive is disposed between the ink layer and the high-filling coating layer to form an adhesive layer, and a thickness of the adhesive layer is less than 0.2 mm.

In another embodiment, between step S502 and step S503, the preparation process further includes: laminating, under vacuum and at 40~80°C, a decorative film and the initially cured 3D structure obtained after step S502, placing the decorative film and the 3D structure on a pre-laminating jig, performing plane hot pressing at 80~150°C for 30~60s, and then performing cold pressing at normal temperature at 0~1 MPa for 20~100s; and correspondingly, in step S503, performing heating in the 3D mold is to soften and thermally bend the obtained plane laminated structure to obtain the 3D laminated structure. The decorative film includes a laminated structure of an ink layer, an optical coating layer, a texture layer, and a plastic substrate layer. The decorative film has a glare effect, and a film thickness is less than 0.15 mm. When laminating is performed, the ink layer is in contact with the high-filling coating layer; and correspondingly, the highlight layer is formed at the plastic substrate layer. In an embodiment, when the decorative film and the laminated structure obtained in step S402 are laminated, an adhesive is further included, where the adhesive is disposed between the ink layer and the high-filling coating layer to form an adhesive layer, and a thickness of the adhesive layer is less than 0.2 mm. In this embodiment, all resins used at the adhesive layer, the ink layer, the optical coating layer, the texture layer, and the plastic substrate layer are thermoplastic resins, so as to meet a process requirement in which a plane laminated structure is formed first by performing hot pressing at a low temperature, and then the plane laminated structure is softened at a high temperature to perform 3D thermal bending molding.

In an embodiment, the decorative film further includes a highlight layer disposed at the plastic substrate layer. In this case, no highlight layer needs to be painted in step S504.

In the embodiment, the prepreg, the adhesive layer, the ink layer, the optical coating layer, the texture layer, and the plastic substrate layer meet the foregoing performance parameters. Details are not described herein again in this application.

FIG. 6 is a schematic diagram of a structure of a battery cover according to a second embodiment of this application. In this embodiment, the battery cover 300 includes a woven glass fiber plate layer 3601, a unidirectional glass fiber plate layer 3602, and a highlight layer 3607 that are sequentially laminated. Performance parameters of the woven glass fiber plate layer 3601 and the highlight layer 3607 are the same as those described above. Details are not described herein again in the present invention.

A function of the unidirectional glass fiber plate layer 3602 is to shield a woven texture of the woven glass fiber plate layer 3601 from affecting a specular highlight effect of the highlight layer 3607. The unidirectional glass fiber plate layer 3602 is a plate made of a unidirectional glass fiber, where the glass fiber includes but is not limited to E-glass fiber, S-glass fiber, C-glass fiber, A-glass fiber, and the like, and may be the same as or different from a glass fiber material of the woven glass fiber plate layer 3601. In an embodiment, a resin solution includes a matrix resin, a curing agent, a promoter, and a solvent. In an embodiment, the matrix resin is a thermosetting resin, and includes but is not limited to a bisphenol A epoxy resin, a phenolic epoxy resin, an alicyclic epoxy resin, a nitrogen-containing multifunctional epoxy resin, a phenolic resin, a bismaleimide resin, a benzoxazine resin, and the like. In an embodiment, the curing agent may be selected from a phenolic type curing agent, an acid anhydride curing agent, an amine curing agent, a dicyandiamide curing agent, or the like, for example, a nadikic anhydride, a methylnadikic anhydride, a methyl tetrahydrophthalic anhydride, a diphenyl ether tetra-phthalic anhydride, a benzophenonetetracarboxylic dianhydride, a methyl-cyclohexene-tetracarboxylic anhydride, a diphenylbenzidine, or a dicyandiamide. In an embodiment, the promoter includes an imidazole promoter or an amine promoter, such as imidazole or 2-methylimidazole. In an embodiment, the thermosetting resin is a thermosetting epoxy resin, and the curing agent is an amine curing agent. In an embodiment, the resin solution includes a thermoplastic resin and a solvent, and the thermoplastic resin includes but is not limited to a thermoplastic polyurethane, a thermoplastic polyamide, and the like.

The thickness of the unidirectional glass fiber plate layer 3602 is less than 0.2 mm. In an embodiment, a thickness of the unidirectional glass fiber plate layer 3602 is less than 0.15 mm. In an embodiment, a total thickness of the woven glass fiber plate layer 3601 and the unidirectional glass fiber plate layer 3602 is 0.35~0.45 mm. In an embodiment, a light transmittance of the unidirectional glass fiber plate layer 3602 is less than 0.05%. In an embodiment, a thickness of the unidirectional glass fiber plate layer 3602 is 0.

The difference between a heat shrinkage of the unidirectional glass fiber plate layer 3602 and a heat shrinkage of the woven glass fiber plate layer 3601 does not exceed 20% of the heat shrinkage of the woven glass fiber plate layer 3601. In an embodiment, a difference between a heat shrinkage of the unidirectional glass fiber plate layer 3602 and a heat shrinkage of the woven glass fiber plate layer 3601 does not exceed 15% of the heat shrinkage of the woven glass fiber plate layer 3601. In an embodiment, a difference between a heat shrinkage of the unidirectional glass fiber plate layer 3602 and a heat shrinkage of the woven glass fiber plate layer 3601 does not exceed 10% of the heat shrinkage of the woven glass fiber plate layer 3601. In this solution, a light transmittance of the unidirectional glass fiber plate layer 3602 is less than 0.05%, and when a difference between a heat shrinkage of the unidirectional glass fiber plate layer 3602 and a heat shrinkage of the woven glass fiber plate layer 3601 does not exceed 20% of the heat shrinkage of the woven glass fiber plate layer 3601, a fiber woven texture can be covered, and no fiber woven texture is formed during hot pressing, so that display of an optical texture such as highlight is not affected.

The battery cover further includes an ink layer 3603 disposed between the unidirectional glass fiber plate layer 3602 and the highlight layer 3607.

In an embodiment, the battery cover further includes an optical coating layer 3604, a texture layer 3605, and a plastic substrate layer 3606 that are disposed between the unidirectional glass fiber plate layer 3602 and the highlight layer 3607, and the optical coating layer 3604, the texture layer 3605, and the plastic substrate layer 3606 form a laminated structure of a decorative film with a glare effect, where the optical coating layer 3604 is in contact with the unidirectional glass fiber plate layer 3602, and the plastic substrate layer 3606 is in contact with the highlight layer 3607. The optical coating layer 3604, the texture layer 3605, and the plastic substrate layer 3606 meet performance parameters of the foregoing layers. Details are not described herein again in the present invention.

In an embodiment, the battery cover further includes an ink layer 3603 disposed between the unidirectional glass fiber plate layer 3602 and the optical coating layer 3604. The ink layer 3603, on the one hand, is used as a protective layer of the optical coating layer 3604, and, on the other hand, can improve a shielding effect. In this solution, the ink layer 3603 may be formed at the optical coating layer 3604 through screen printing, coating, or spraying.

In an embodiment, the battery cover 300 further includes an adhesive layer (not shown in the figure), where the adhesive layer may be disposed between the ink layer 3603 and the unidirectional glass fiber plate layer 3602, or may be disposed between the ink layer 3603 and the optical coating layer 3604, to perform an adhesive function.

The ink layer 3603, the optical coating layer 3604, the texture layer 3605, the plastic substrate layer 3606, and the adhesive layer meet the foregoing performance parameters. Details are not described herein again in this application.

The battery cover may be prepared according to the foregoing three methods. Details are not described herein again in the present invention.

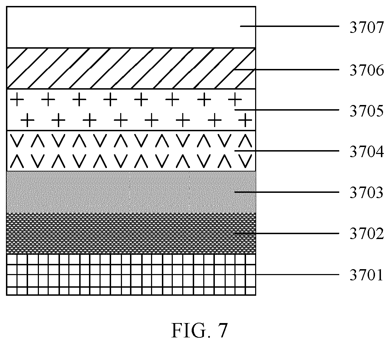

FIG. 7 is a schematic diagram of a structure of a battery cover according to a comparative example of this application. In this example, the battery cover 300 includes a woven glass fiber plate layer 3701, an adhesive layer 3702, an ink layer 3703, and a highlight layer 3707 that are sequentially laminated. Performance parameters of the woven glass fiber plate layer 3701 and the highlight layer 3707 are the same as those described above. Details are not described herein again in the present invention.

In this example, the adhesive layer 3702 and the ink layer 3703 are used to shield a fiber woven texture, so that display of an optical texture effect is not affected after 3D hot pressing. In an example, a thickness of the ink layer 3703 is 10~60 µm. In an example, a thickness of the ink layer 3703 is 15~50 µm. In an example, the ink layer 3703 may be a black ink layer, a white ink layer, or a gray ink layer, and a light transmittance thereof is less than 0.05%. In an example, a light transmittance of the ink layer 3703 is 0. The ink layer 3703 may be formed at the adhesive layer 3702 through screen printing, coating, or spraying.

In an example, a thickness of the adhesive layer 3702 is less than 0.2 mm. In an example, a thickness of the adhesive layer 3702 is less than 0.15 mm. In an example, a light transmittance of the adhesive layer 3702 is less than 0.05%. In an example, a light transmittance of the adhesive layer 3702 is 0. In an example, a haze value of the adhesive layer is less than 220.

In an example, the adhesive layer 3702 may be a light shielding tape, a light shielding adhesive, or the like.

In an example, a total light transmittance of the adhesive layer 3702 and the ink layer 3703 is less than 0.05%. In an example, a total light transmittance of the adhesive layer 3702 and the ink layer 3703 is 0. In an example, a difference between a heat shrinkage of the adhesive layer 3702 and a heat shrinkage of the woven glass fiber plate layer 3701 and a difference between a heat shrinkage of the ink layer 3703 and the heat shrinkage of the woven glass fiber plate layer 3701 do not exceed 20% of the heat shrinkage of the woven glass fiber plate layer 3701. In an embodiment, a difference between a heat shrinkage of the adhesive layer 3702 and a heat shrinkage of the woven glass fiber plate layer 3701 and a difference between a heat shrinkage of the ink layer 3703 and the heat shrinkage of the woven glass fiber plate layer 3701 do not exceed 15% of the heat shrinkage of the woven glass fiber plate layer 3201. In an example, a difference between a heat shrinkage of the adhesive layer 3702 and a heat shrinkage of the woven glass fiber plate layer 3701 and a difference between a heat shrinkage of the ink layer 3703 and the heat shrinkage of the woven glass fiber plate layer 3701 do not exceed 10% of the heat shrinkage of the woven glass fiber plate layer 3701. In this solution, a total light transmittance of the adhesive layer 3702 and the ink layer 3703 is less than 0.05%, and when the difference between the heat shrinkage of the adhesive layer 3702 and the heat shrinkage of the woven glass fiber plate layer 3701 and the difference between the heat shrinkage of the ink layer 3703 and the heat shrinkage of the woven glass fiber plate layer 3701 do not exceed 20% of the heat shrinkage of the woven glass fiber plate layer 3701, a fiber woven texture can be covered, and no fiber woven texture is formed at the adhesive layer 3702 and even the ink layer 3703 during hot pressing, so that display of an optical texture such as glare is not affected.

In an example, the battery cover further includes an optical coating layer 3704, a texture layer 3705, and a plastic substrate layer 3706 that are disposed between the ink layer 3703 and the highlight layer 3707, and the optical coating layer 3704, the texture layer 3705, and the plastic substrate layer 3706 form a laminated structure of a decorative film with a glare effect, where the optical coating layer 3704 is in contact with the ink layer 3703, and the plastic substrate layer 3706 is in contact with the highlight layer 3707. The optical coating layer 3704, the texture layer 3705, the plastic substrate layer 3706 meet the foregoing performance parameters. Details are not described herein again in this application. In this solution, the ink layer 3703 may be formed at the optical coating layer 3604 through screen printing, coating, or spraying.

The ink layer 3603, the optical coating layer 3604, the texture layer 3605, the plastic substrate layer 3606, and the adhesive layer meet the foregoing performance parameters. Details are not described herein again in this application.

The battery cover may be prepared according to the foregoing three methods. Details are not described herein again in the present invention.

After the 3D battery cover provided in the present invention is assembled with components such as a display screen, a middle frame, a main board, a memory, and a power supply, a mobile phone terminal may be obtained. When a user uses the mobile phone terminal, a battery cover of the mobile phone terminal is of a glass plate structure, has a specular highlight effect, and does not present a woven texture of a woven glass fiber plate, and the mobile phone is relatively beautiful. Further, when the battery cover has a glare structure layer, and the user uses the mobile phone terminal, the battery cover has a glare effect similar to a CD texture or a laser texture, does not present a woven texture, and is not affected by a woven texture, and a back cover of the mobile phone presents rich optical effects.

The following further describes the battery cover of a mobile phone provided in this application with reference to examples.

### Comparative Example 1

A decorative film is provided, and the decorative film includes a PC substrate layer, a UV film transferred onto the PC substrate layer, an optical coating layer formed on the UV film by using a PVD coating layer, and an ink layer sprayed on the optical coating layer, where a thickness of the PC substrate layer is 0.1 mm, a tensile strength is 50 MPa, and an elongation is 180%; and a thickness of the UV film is 10 µm, a thickness of the optical coating layer is 500 nm, and a thickness of the ink layer is 50 µm.

A woven glass fiber cloth is coated in a resin solution including an epoxy resin and an amine curing agent, and is dried to obtain a prepreg with a thickness of 0.1 mm. Four layers of woven glass fiber cloth prepreg are laminated in a 3D mold, and are cut and hot pressed at 180 °C for 20 minutes, and then cold pressed at normal temperature at 0.5 MPa for 60s to form a 3D glass fiber plate.

The decorative film, an adhesive, and the 3D glass fiber plate are laminated under vacuum and at 60°C, placed on a pre-laminating jig, then hot pressed for the second time 120°C for 40s for lamination, and then cold pressed at normal temperature at 0.5 MPa for 60s.

In the obtained laminated structure, CNC is performed to leave an epitaxial gate location, and a jig is designed to perform highlight spraying to form a highlight layer with a thickness of 20 µm, so as to obtain a 3D battery cover with the glare and highlight effects. In the laminated structure, a heat shrinkage difference between the PC substrate layer of the decorative film, an adhesive layer, and the glass fiber plate layer does not exceed 20%.

After the 3D battery cover provided in this example is assembled with components such as a display screen, a middle frame, a main board, a memory, and a power supply, a mobile phone terminal may be obtained. When a user uses the mobile phone terminal, a battery cover of the mobile phone terminal is of a glass plate structure, has a specular highlight effect and a glare effect such as a CD texture or a laser texture, does not present a woven texture of a woven glass fiber plate, and is not affected by a woven texture, and rich optical effects are presented.

### Comparative Example 2

A difference from Example 1 lies in that the decorative film includes a highlight layer that is coated on the other side of the PC substrate layer and has a thickness of 20 µm, and subsequently no highlight layer needs to be sprayed again.

### Comparative Example 3

A difference from Example 1 lies in that a woven glass fiber cloth is coated in a thermoplastic resin solution, and is dried to obtain a prepreg with a thickness of 0.1 mm. Four layers of woven glass fiber cloth prepreg are laminated, cut, and cured at 160 °C for 20 minutes to obtain a glass fiber plate. The decorative film, an adhesive, and glass fiber plate are laminated under vacuum and at 60°C, placed on a pre-laminating jig, and hot pressed at 120°C for 40s for lamination, to obtain a plane laminated structure.

The laminated structure obtained by performing CNC is softened in a 3D mold at 190 °C for 20 minutes to obtain a 3D laminated structure through thermal bending molding.

In the obtained 3D laminated structure, CNC is performed to leave an epitaxial gate location, and a jig is designed to perform highlight spraying to form a highlight layer with a thickness of 20 µm, so as to obtain a 3D battery cover with the glare and highlight effects.

In the laminated structure, a heat shrinkage difference between the PC substrate layer of the decorative film, an adhesive layer, and the glass fiber plate layer does not exceed 20%.

### Inventive example 1

A difference from Comparative Example 1 lies in that a cover resin layer is disposed between the decorative film and the glass fiber plate, thereby further increasing covering power. A thickness of the cover resin layer is 0.1 mm.

In the laminated structure, a heat shrinkage difference between the PC substrate layer of the decorative film, an adhesive layer, and the glass fiber plate layer does not exceed 20%.

### Inventive Example 2

A special modified resin is provided.

A woven glass fiber cloth is coated in a resin solution including an epoxy resin and an amine curing agent, and is dried to obtain a prepreg with a thickness of 0.1 mm. Four layers of woven glass fiber cloth prepreg are laminated and coated with the special modified resin with a thickness of 0.05 mm, so as to form a plane laminated structure through initial thermal curing.

The plane laminated structure obtained is cut and thermal bent in a 3D mold at 180 °C to form a 3D laminated structure.

In the obtained laminated structure, CNC is performed to leave an epitaxial gate location, and a jig is designed to perform highlight spraying, so as to obtain a 3D battery cover with the glare and highlight effects.

In the laminated structure, a heat shrinkage difference between the special modified resin and the glass fiber plate layer does not exceed 20%.

### Inventive Example 3

A unidirectional glass fiber cloth is provided, and the unidirectional glass fiber cloth is coated in a resin solution including an epoxy resin and an amine curing agent, and is dried to obtain a cover layer with a thickness of 0.1 mm.

The woven glass fiber cloth is coated in a resin solution including an epoxy resin and an amine curing agent, and is dried to obtain a prepreg with a thickness of 0.1 mm. Three layers of woven glass fiber cloth prepreg and one layer of cover layer are laminated, cut, and hot pressed at 180 °C in a 3D mold to obtain a 3D laminated structure.

In the obtained laminated structure, CNC is performed to leave an epitaxial gate location, and a jig is designed to perform highlight spraying, so as to obtain a 3D battery cover with the glare and highlight effects.

### Inventive Example 4

A woven glass fiber cloth is coated in a resin solution including an epoxy resin and an amine curing agent, and is dried to obtain a prepreg with a thickness of 0.1 mm. Four layers of woven glass fiber cloth prepreg are laminated in a 3D mold, and are cut and hot pressed at 180 °C for 20 minutes, and then cold pressed at normal temperature at 0.5 MPa for 60s to form a 3D glass fiber plate.

A high-filling coating is coated to the 3D glass fiber plate to form a high-filling coating layer with a thickness not exceeding 0.1 mm, to obtain a 3D laminated structure.

In the obtained laminated structure, CNC is performed to leave an epitaxial gate location, and a jig is designed to perform highlight spraying, so as to obtain a 3D battery cover with the glare and highlight effects.

In the laminated structure, a heat shrinkage difference between the high-filling coating layer and the glass fiber plate layer does not exceed 20%.

After the 3D battery cover provided in this example is assembled with components such as a display screen, a middle frame, a main board, a memory, and a power supply, a mobile phone terminal may be obtained. When a user uses the mobile phone terminal, a battery cover of the mobile phone terminal is of a glass plate structure, has a specular highlight effect, does not present a woven texture of a woven glass fiber plate, and is not affected by a woven texture, and rich optical effects are presented.

The foregoing descriptions are merely specific implementations of this application, but are not intended to limit the protection scope of this application. Any variation or replacement made within the technical scope disclosed in this application shall fall within the protection scope of this application. Therefore, the protection scope of this application shall be subject to the protection scope of the claims.

## Claims

1. A housing assembly, comprising a woven glass fiber plate layer, a cover layer, and a highlight layer that are sequentially laminated, wherein the highlight layer is configured to create a specular highlight effect, wherein
a heat shrinkage difference between the woven glass fiber plate layer and the cover layer does not exceed 20%, wherein the heat shrinkage is a percentage of a difference between sizes of a film before and after hot processing;
a thickness of the cover layer does not exceed 0.2 mm; and
a light transmittance of the cover layer does not exceed 0.05%, wherein the cover layer is a high-filling coating layer formed of a filler, a solvent, and a film forming resin, a cover resin layer or an unidirectional glass fiber plate layer,
wherein the housing assembly further comprises an ink layer disposed between the cover layer and the highlight layer.

2. The housing assembly according to claim 1, further comprising an optical coating layer, a texture layer, and a plastic substrate layer that are sequentially disposed between the ink layer and the highlight layer, wherein the optical coating layer is in contact with the ink layer, and the plastic substrate layer is in contact with the highlight layer; and
an elongation of the plastic substrate layer is not less than 150%, wherein the elongation is a percentage of a ratio of a total deformation ΔL of a gauge segment after the sample is stretched and broken to an original gauge length L: δ=ΔL/L× 100%; and a tensile strength in a tensile test of applying a tensile stress on the plastic substrate layer until it is broken is not less than 50 MPa.

3. The housing assembly according to claim 1, further comprising a decorative film disposed between the cover layer and the highlight layer, wherein the decorative film comprises the ink layer, an optical coating layer, a texture layer, and a plastic substrate layer that are sequentially disposed, and the ink layer is in contact with the cover layer; and
an elongation of the plastic substrate layer is not less than 150%, wherein the elongation is a percentage of a ratio of a total deformation ΔL of a gauge segment after the sample is stretched and broken to an original gauge length L: δ=ΔL/L× 100%; and a tensile strength in a tensile test of applying a tensile stress on the plastic substrate layer until it is broken is not less than 50 MPa.

4. The housing assembly according to any one of claims 1 to 3, wherein a thickness of the ink layer does not exceed 0.1 mm;
a light transmittance of the ink layer does not exceed 0.05%; and
a heat shrinkage difference between the woven glass fiber plate layer, the cover layer, and the ink layer does not exceed 20%.

5. The housing assembly according to any one of claims 1 to 4, wherein the cover layer is a cover resin layer, and a heat shrinkage difference between the woven glass fiber plate layer and the cover resin layer does not exceed 15%; and
a thickness of the cover resin layer does not exceed 0.15 mm.

6. The housing assembly according to any one of claims 1 to 4, wherein the cover layer is a high-filling coating layer formed of a filler, a solvent, and a film forming resin, and a heat shrinkage difference between the woven glass fiber plate layer and the high-filling coating layer does not exceed 15%; and
a thickness of the high-filling coating layer does not exceed 0.15 mm.

7. The housing assembly according to any one of claims 1 to 4, wherein the cover layer is a unidirectional glass fiber plate layer, and a heat shrinkage difference between the woven glass fiber plate layer and the unidirectional glass fiber plate layer does not exceed 15%; and
a thickness of the unidirectional glass fiber plate layer does not exceed 0.15 mm.

8. The housing assembly according to any one of claims 1 to 7, wherein the 3D housing assembly is a battery cover of a mobile phone terminal.

9. A method for preparing a housing assembly, comprising the following steps:
performing 3D hot pressing molding on a woven glass fiber cloth prepreg, and then sequentially forming a cover layer and a coating highlight layer that is configured to create a specular highlight effect to obtain a housing assembly, wherein
a heat shrinkage difference between the woven glass fiber plate layer and the cover layer does not exceed 20%, wherein the heat shrinkage is a percentage of a difference between sizes of a film before and after hot processing;
a thickness of the cover layer is less than 0.2 mm; and
a light transmittance of the cover layer is less than 0.05%, wherein the cover layer is a high-filling coating layer formed of a filler, a solvent, and a film forming resin, a cover resin layer or an unidirectional glass fiber plate layer, the method further comprising:
coating an ink layer on the cover layer after the cover layer is formed.

10. A method for preparing a housing assembly, comprising the following steps:
laminating a woven glass fiber cloth prepreg and then laminating the woven glass fiber cloth prepreg with a cover layer, and coating an obtained laminated structure with a highlight layer after 3D hot pressing molding, to obtain the housing assembly, wherein the highlight layer is configured to create a specular highlight effect, where
a heat shrinkage difference between the woven glass fiber plate layer and the cover layer does not exceed 20%, wherein the heat shrinkage is a percentage of a difference between sizes of a film before and after hot processing;
a thickness of the cover layer is less than 0.2 mm; and
a light transmittance of the cover layer is less than 0.05%, wherein the cover layer is a high-filling coating layer formed of a filler, a solvent, and a film forming resin, a cover resin layer or an unidirectional glass fiber plate layer, the method further comprising:
coating an ink layer on the cover layer after the cover layer is formed.

11. A method for preparing a housing assembly, comprising the following steps:
impregnating and curing a woven glass fiber cloth in a thermoplastic resin, to obtain a thermoplastic resin glass fiber plate; and
forming a cover layer on the thermoplastic resin glass fiber plate, and coating the obtained laminated structure with a highlight layer after 3D hot pressing molding, wherein the highlight layer is configured to create a specular highlight effect, wherein
a heat shrinkage difference between the woven glass fiber plate layer and the cover layer does not exceed 20%, wherein the heat shrinkage is a percentage of a difference between sizes of a film before and after hot processing;
a thickness of the cover layer is less than 0.2 mm; and
a light transmittance of the cover layer is less than 0.05%, wherein the cover layer is a high-filling coating layer formed of a filler, a solvent, and a film forming resin, a cover resin layer or an unidirectional glass fiber plate layer, the method further comprising:
coating an ink layer on the cover layer after the cover layer is formed.

12. A terminal, comprising the housing assembly according to any one of claims 1 to 8.

## Patentansprüche

1. Gehäusebaugruppe, umfassend eine Schicht aus gewebter Glasfaserplatte, eine Deckschicht und eine Glanzschicht, die nacheinander laminiert sind, wobei die Glanzschicht dazu konfiguriert ist, einen spiegelnden Glanzeffekt zu erzeugen, wobei
ein Wärmeschrumpfungsunterschied zwischen der Schicht aus gewebter Glasfaserplatte und der Deckschicht 20 % nicht überschreitet, wobei die Wärmeschrumpfung ein Prozentsatz der Differenz zwischen den Größen eines Films vor und nach der Heißverarbeitung ist;
eine Dicke der Deckschicht 0,2 mm nicht überschreitet; und
eine Lichtdurchlässigkeit der Deckschicht 0,05 % nicht überschreitet, wobei die Deckschicht eine hochgefüllte Beschichtungsschicht ist, die aus einem Füllstoff, einem Lösungsmittel und einem filmbildenden Harz, einer Deckharzschicht oder einer unidirektionalen Glasfaserplattenschicht gebildet ist,
wobei die Gehäusebaugruppe ferner eine Tintenschicht umfasst, die zwischen der Deckschicht und der Glanzschicht angeordnet ist.

2. Gehäusebaugruppe nach Anspruch 1, ferner umfassend eine optische Beschichtungsschicht, eine Strukturschicht und eine Kunststoffsubstratschicht, die nacheinander zwischen der Tintenschicht und der Glanzschicht angeordnet sind, wobei die optische Beschichtungsschicht in Kontakt mit der Tintenschicht steht und die Kunststoffsubstratschicht in Kontakt mit der Glanzschicht steht; und
eine Dehnung der Kunststoffsubstratschicht nicht weniger als 150 % beträgt, wobei die Dehnung ein Prozentsatz des Verhältnisses einer Gesamtverformung ΔL eines Messabschnitts, nachdem die Probe gedehnt und gebrochen wurde, zu einer ursprünglichen Messlänge L ist: δ=ΔL/L×100%; und eine Zugfestigkeit in einem Zugversuch, bei dem eine Zugspannung auf die Kunststoffsubstratschicht ausgeübt wird, bis sie bricht, nicht weniger als 50 MPa beträgt.

3. Gehäusebaugruppe nach Anspruch 1, ferner umfassend einen Dekorfilm, der zwischen der Deckschicht und der Glanzschicht angeordnet ist, wobei der Dekorfilm die Tintenschicht, eine optische Beschichtungsschicht, eine Strukturschicht und eine Kunststoffsubstratschicht umfasst, die nacheinander angeordnet sind, und die Tintenschicht in Kontakt mit der Deckschicht steht; und
eine Dehnung der Kunststoffsubstratschicht nicht weniger als 150 % beträgt, wobei die Dehnung ein Prozentsatz des Verhältnisses einer Gesamtverformung ΔL eines Messabschnitts, nachdem die Probe gedehnt und gebrochen wurde, zu einer ursprünglichen Messlänge L ist: δ=ΔL/L×100%; und eine Zugfestigkeit in einem Zugversuch, bei dem eine Zugspannung auf die Kunststoffsubstratschicht ausgeübt wird, bis sie bricht, nicht weniger als 50 MPa beträgt.

4. Gehäusebaugruppe nach einem der Ansprüche 1 bis 3, wobei eine Dicke der Tintenschicht 0,1 mm nicht überschreitet;
eine Lichtdurchlässigkeit der Tintenschicht 0,05 % nicht überschreitet; und
ein Wärmeschrumpfungsunterschied zwischen der Gewebeglasfaserplattenschicht, der Deckschicht und der Farbschicht überschreitet 20 % nicht.

5. Gehäusebaugruppe nach einem der Ansprüche 1 bis 4, wobei die Deckschicht eine Deckharzschicht ist und ein Wärmeschrumpfungsunterschied zwischen der Gewebeglasfaserplattenschicht und der Deckharzschicht 15 % nicht überschreitet; und
eine Dicke der Deckharzschicht 0,15 mm nicht überschreitet.

6. Gehäusebaugruppe nach einem der Ansprüche 1 bis 4, wobei die Deckschicht eine hochgefüllte Beschichtungsschicht ist, die aus einem Füllstoff, einem Lösungsmittel und einem filmbildenden Harz gebildet ist, und ein Wärmeschrumpfungsunterschied zwischen der Gewebeglasfaserplattenschicht und der hochgefüllten Beschichtungsschicht 15 % nicht überschreitet; und
eine Dicke der hochgefüllten Beschichtungsschicht 0,15 mm nicht überschreitet.

7. Gehäusebaugruppe nach einem der Ansprüche 1 bis 4, wobei die Deckschicht eine unidirektionale Glasfaserplattenschicht ist und ein Wärmeschrumpfungsunterschied zwischen der Gewebeglasfaserplattenschicht und der unidirektionalen Glasfaserplattenschicht 15 % nicht überschreitet; und
eine Dicke der unidirektionalen Glasfaserplattenschicht 0,15 mm nicht überschreitet.

8. Gehäusebaugruppe nach einem der Ansprüche 1 bis 7, wobei die 3D-Gehäusebaugruppe eine Batterieabdeckung eines Mobiltelefonendgeräts ist.

9. Verfahren zur Herstellung einer Gehäusebaugruppe, umfassend die folgenden Schritte:
Durchführen einer 3D-Warmpressformung an einem Gewebeglasfasergewebe-Prepreg und anschließend sequenzielles Bilden einer Deckschicht und einer Beschichtungshighlightschicht, die dazu konfiguriert ist, einen spiegelnden Highlight-Effekt zu erzeugen, um eine Gehäusebaugruppe zu erhalten, wobei
ein Wärmeschrumpfungsunterschied zwischen der Gewebeglasfaserplattenschicht und der Deckschicht 20 % nicht überschreitet, wobei die Wärmeschrumpfung ein Prozentsatz der Differenz zwischen den Größen eines Films vor und nach der Heißverarbeitung ist;
eine Dicke der Deckschicht weniger als 0,2 mm beträgt; und
eine Lichtdurchlässigkeit der Deckschicht weniger als 0,05 % beträgt, wobei die Deckschicht eine hochgefüllte Beschichtungsschicht, gebildet aus einem Füllstoff, einem Lösungsmittel und einem filmbildenden Harz, eine Deckharzschicht oder eine unidirektionale Glasfaserplattenschicht ist, wobei das Verfahren ferner umfasst:
Auftragen einer Farbschicht auf die Deckschicht, nachdem die Deckschicht gebildet wurde.

10. Verfahren zur Herstellung einer Gehäusebaugruppe, umfassend die folgenden Schritte:
Laminieren eines Prepregs aus gewebtem Glasfasergewebe und anschließendes Laminieren des Prepregs aus gewebtem Glasfasergewebe mit einer Deckschicht, sowie Beschichten einer erhaltenen Laminatstruktur mit einer Hochglanzschicht nach dem 3D-Heißpressformen, um die Gehäusebaugruppe zu erhalten, wobei die Hochglanzschicht dazu konfiguriert ist, einen spiegelnden Hochglanzeffekt zu erzeugen, wobei
ein Wärmeschrumpfungsunterschied zwischen der Glasfasergewebe-Plattenschicht und der Deckschicht 20 % nicht überschreitet, wobei die Wärmeschrumpfung ein Prozentsatz der Differenz zwischen den Größen eines Films vor und nach der Heißverarbeitung ist;
eine Dicke der Deckschicht weniger als 0,2 mm beträgt; und
eine Lichtdurchlässigkeit der Deckschicht weniger als 0,05 % beträgt, wobei die Deckschicht eine hochgefüllte Beschichtungsschicht ist, die aus einem Füllstoff, einem Lösungsmittel und einem filmbildenden Harz, einer Deckharzschicht oder einer unidirektionalen Glasfaserplattenschicht gebildet ist, wobei das Verfahren ferner umfasst:
Auftragen einer Tintenschicht auf die Deckschicht, nachdem die Deckschicht gebildet wurde.

11. Verfahren zur Herstellung einer Gehäusebaugruppe, umfassend die folgenden Schritte:
Imprägnieren und Härten eines gewebten Glasfasergewebes in einem thermoplastischen Harz, um eine thermoplastische Harz-Glasfaserplatte zu erhalten; und
Bilden einer Deckschicht auf der thermoplastischen Harz-Glasfaserplatte und Beschichten der erhaltenen Laminatstruktur mit einer Hochglanzschicht nach dem 3D-Heißpressformen, wobei die Hochglanzschicht dazu konfiguriert ist, einen spiegelnden Hochglanzeffekt zu erzeugen, wobei
ein Wärmeschrumpfungsunterschied zwischen der Glasfasergewebe-Plattenschicht und der Deckschicht 20 % nicht überschreitet, wobei die Wärmeschrumpfung ein Prozentsatz der Differenz zwischen den Größen eines Films vor und nach der Heißverarbeitung ist;
eine Dicke der Deckschicht weniger als 0,2 mm beträgt; und
eine Lichtdurchlässigkeit der Deckschicht weniger als 0,05 % beträgt, wobei die Deckschicht eine hochgefüllte Beschichtungsschicht ist, die aus einem Füllstoff, einem Lösungsmittel und einem filmbildenden Harz, einer Deckharzschicht oder einer unidirektionalen Glasfaserplattenschicht gebildet ist, wobei das Verfahren ferner umfasst:
Auftragen einer Tintenschicht auf die Deckschicht, nachdem die Deckschicht gebildet wurde.

12. Endgerät, umfassend die Gehäusebaugruppe nach einem der Ansprüche 1 bis 8.

## Revendications

1. Ensemble de boîtier, comprenant une couche de plaque en fibre de verre tissée, une couche de couverture et une couche de surbrillance qui sont stratifiées séquentiellement, dans lequel la couche de surbrillance est configurée pour créer un effet de réflexion spéculaire, dans lequel
une différence de retrait thermique entre la couche de plaque en fibre de verre tissée et la couche de couverture ne dépasse pas 20 %, dans lequel le retrait thermique est un pourcentage de la différence entre les tailles d'un film avant et après traitement thermique ;
une épaisseur de la couche de couverture ne dépasse pas 0,2 mm ; et
une transmission lumineuse de la couche de couverture ne dépasse pas 0,05 %, dans lequel la couche de couverture est une couche de revêtement à haut taux de charge formée d'une charge, d'un solvant et d'une résine filmogène, une couche de résine de couverture ou une couche de plaque en fibre de verre unidirectionnelle,
dans lequel l'ensemble de boîtier comprend en outre une couche d'encre disposée entre la couche de couverture et la couche de surbrillance.

2. Ensemble de boîtier selon la revendication 1, comprenant en outre une couche de revêtement optique, une couche de texture et une couche de substrat plastique qui sont disposées séquentiellement entre la couche d'encre et la couche de surbrillance, dans lequel la couche de revêtement optique est en contact avec la couche d'encre, et la couche de substrat plastique est en contact avec la couche de surbrillance ; et
un allongement de la couche de substrat plastique n'est pas inférieur à 150 %, dans lequel l'allongement est un pourcentage du rapport d'une déformation totale ΔL d'un segment de mesure après que l'échantillon est étiré et rompu à une longueur de mesure originale L : δ=ΔL/L×100 % ; et une résistance à la traction lors d'un essai de traction consistant à appliquer une contrainte de traction sur la couche de substrat plastique jusqu'à sa rupture n'est pas inférieure à 50 MPa.

3. Ensemble de boîtier selon la revendication 1, comprenant en outre un film décoratif disposé entre la couche de couverture et la couche de surbrillance, dans lequel le film décoratif comprend la couche d'encre, une couche de revêtement optique, une couche de texture et une couche de substrat plastique qui sont disposées séquentiellement, et la couche d'encre est en contact avec la couche de couverture ; et
un allongement de la couche de substrat plastique n'est pas inférieur à 150 %, dans lequel l'allongement est un pourcentage du rapport d'une déformation totale ΔL d'un segment de mesure après que l'échantillon est étiré et rompu à une longueur de mesure originale L : δ=ΔL/L×100 % ; et une résistance à la traction lors d'un essai de traction consistant à appliquer une contrainte de traction sur la couche de substrat plastique jusqu'à sa rupture n'est pas inférieure à 50 MPa.

4. Ensemble de boîtier selon l'une quelconque des revendications 1 à 3, dans lequel une épaisseur de la couche d'encre ne dépasse pas 0,1 mm ;
une transmission lumineuse de la couche d'encre ne dépasse pas 0,05 % ; et
une différence de retrait thermique entre la couche de plaque de fibre de verre tissée, la couche de couverture et la couche d'encre ne dépasse pas 20 %.

5. L'ensemble de boîtier selon l'une quelconque des revendications 1 à 4, dans lequel la couche de couverture est une couche de résine de couverture, et une différence de retrait thermique entre la couche de plaque de fibre de verre tissée et la couche de résine de couverture ne dépasse pas 15 % ; et
une épaisseur de la couche de résine de couverture ne dépasse pas 0,15 mm.

6. L'ensemble de boîtier selon l'une quelconque des revendications 1 à 4, dans lequel la couche de couverture est une couche de revêtement à haut taux de charge formée d'une charge, d'un solvant et d'une résine filmogène, et une différence de retrait thermique entre la couche de plaque de fibre de verre tissée et la couche de revêtement à haut taux de charge ne dépasse pas 15 % ; et
une épaisseur de la couche de revêtement à haut taux de charge ne dépasse pas 0,15 mm.

7. L'ensemble de boîtier selon l'une quelconque des revendications 1 à 4, dans lequel la couche de couverture est une couche de plaque de fibre de verre unidirectionnelle, et une différence de retrait thermique entre la couche de plaque de fibre de verre tissée et la couche de plaque de fibre de verre unidirectionnelle ne dépasse pas 15 % ; et
une épaisseur de la couche de plaque de fibre de verre unidirectionnelle ne dépasse pas 0,15 mm.

8. L'ensemble de boîtier selon l'une quelconque des revendications 1 à 7, dans lequel l'ensemble de boîtier 3D est un couvercle de batterie d'un terminal de téléphone mobile.

9. Procédé de préparation d'un ensemble de boîtier, comprenant les étapes suivantes :
effectuer un moulage par pressage à chaud 3D sur un préimprégné de tissu de fibre de verre tissé, puis former séquentiellement une couche de couverture et une couche de revêtement à effet brillant configurée pour créer un effet de réflexion spéculaire afin d'obtenir un ensemble de boîtier, dans lequel
une différence de retrait thermique entre la couche de plaque de fibre de verre tissée et la couche de couverture ne dépasse pas 20 %, dans lequel le retrait thermique est un pourcentage d'une différence entre les tailles d'un film avant et après le traitement à chaud ;
une épaisseur de la couche de couverture est inférieure à 0,2 mm ; et
une transmission lumineuse de la couche de couverture est inférieure à 0,05 %, dans lequel la couche de couverture est une couche de revêtement à haut taux de charge formée d'une charge, d'un solvant et d'une résine filmogène, une couche de résine de couverture ou une couche de plaque de fibre de verre unidirectionnelle, le procédé comprenant en outre :
appliquer une couche d'encre sur la couche de couverture après que la couche de couverture est formée.

10. Procédé de préparation d'un ensemble de boîtier, comprenant les étapes suivantes :
stratification d'un préimprégné de tissu de fibres de verre tissé, puis stratification du préimprégné de tissu de fibres de verre tissé avec une couche de recouvrement, et revêtement d'une structure stratifiée obtenue avec une couche brillante après moulage par pressage à chaud 3D, pour obtenir l'assemblage de boîtier, dans lequel la couche brillante est configurée pour créer un effet de réflexion spéculaire, dans lequel
une différence de retrait thermique entre la couche de plaque de fibres de verre tissées et la couche de recouvrement ne dépasse pas 20 %, dans lequel le retrait thermique est un pourcentage d'une différence entre les dimensions d'un film avant et après traitement à chaud ;
une épaisseur de la couche de recouvrement est inférieure à 0,2 mm ; et
une transmittance lumineuse de la couche de recouvrement est inférieure à 0,05 %, dans lequel la couche de recouvrement est une couche de revêtement à haut taux de charge formée d'une charge, d'un solvant et d'une résine filmogène, d'une couche de résine de recouvrement ou d'une couche de plaque de fibres de verre unidirectionnelles, le procédé comprenant en outre :
le revêtement d'une couche d'encre sur la couche de recouvrement après la formation de la couche de recouvrement.

11. Procédé de préparation d'un assemblage de boîtier, comprenant les étapes suivantes :
l'imprégnation et le durcissement d'un tissu de fibres de verre tissé dans une résine thermoplastique, pour obtenir une plaque de fibres de verre en résine thermoplastique ; et
la formation d'une couche de recouvrement sur la plaque de fibres de verre en résine thermoplastique, et le revêtement de la structure stratifiée obtenue avec une couche brillante après moulage par pressage à chaud 3D, dans lequel la couche brillante est configurée pour créer un effet de réflexion spéculaire, dans lequel
une différence de retrait thermique entre la couche de plaque de fibres de verre tissées et la couche de recouvrement ne dépasse pas 20 %, dans lequel le retrait thermique est un pourcentage d'une différence entre les dimensions d'un film avant et après traitement à chaud ;
une épaisseur de la couche de recouvrement est inférieure à 0,2 mm ; et
une transmittance lumineuse de la couche de recouvrement est inférieure à 0,05 %, dans lequel la couche de recouvrement est une couche de revêtement à haut taux de charge formée d'une charge, d'un solvant et d'une résine filmogène, d'une couche de résine de recouvrement ou d'une couche de plaque de fibres de verre unidirectionnelles, le procédé comprenant en outre :
le revêtement d'une couche d'encre sur la couche de recouvrement après la formation de la couche de recouvrement.

12. Terminal, comprenant l'assemblage de boîtier selon l'une quelconque des revendications 1 à 8.
